# EUROPEAN PATENT APPLICATION

(11) **EP 4 586 031 A1**
(43) Date of publication of application: **16.07.2025**
(21) Application number: 24151635.0
(22) Date of filing: 12.01.2024
(51) Int. Cl.: G05B 19/418, G05B 13/04

(54) **METHOD FOR DETERMINING A DESIGN PARAMETER OF A PLANT**

(71) Applicant: ABB SCHWEIZ AG, 5400 Baden (CH)
(72) Inventor: SCHOCH, Nicolai, 69120 Heidelberg (DE); HOERNICKE, Mario, 76829 Landau (DE); BISKOPING, Matthias, 69493 Hirschberg (DE); GUTERMUTH, Georg, 69115 Heidelberg (DE); MCCABE, Jim, Warrington, WA4 4BT (GB)
(74) Representative: Maiwald GmbH

(57) **Abstract**

A computer implemented method for determining a design parameter of a plant, comprising: receiving a plant topology of the plant, wherein the plant topology comprises a plurality of process equipments (S10); receiving a process model for the respective process equipment for a respective process step, wherein the process model describes a dependency between an input parameter and an output parameter (S20); receiving process data for the respective process step for producing a product with the respective process equipment (S30); determining the design parameter for the plant based on the plant topology, the process model and the process data (S40); providing the determined design parameter for further processing (S50).

## Description

### FIELD OF INVENTION

The present invention relates to a computer implemented method for determining a design parameter of a plant, to a data processing device comprising means for carrying out such a method, a computer program and a computer readable medium.

### BACKGROUND OF THE INVENTION

A plant topology of a plant has a big impact on the efficiency of the plant. In dependency of the plant topology and the corresponding process for manufacturing products such as a chemical compound (e.g. a Hydrogen carbonate) various waste products are generated. The waste products are considered as a problem for the efficiency of the plant.

It has now become apparent that there is a further need to provide a possibility to determine and implement beneficial design changes of the plant in order to increase an efficiency of the plant.

This efficiency may relate to energy efficiency, water efficiency (i.e., efficient usage of water, or minimization of waste water), CO2 efficiency (i.e., CO2 exhaust fumes reduction/minimization), etc.

### SUMMARY OF THE INVENTION

In view of the above, it is an object of the present invention to provide a method for determining a design parameter of a plant, in particular it is an object of the present invention to provide an improved method for determining a design parameter of a plant. The dependent claims refer to preferred embodiments of the invention.

A first aspect of the present disclosure relates to a computer implemented method for determining a design parameter of a plant, comprising: receiving a plant topology of the plant, wherein the plant topology comprises a plurality of process equipments and their connections; receiving a process model for the respective process equipment for a respective process step, wherein the process model describes a dependency between an input parameter and an output parameter; receiving process data for the respective process step for producing a product with the respective process equipment; determining the design parameter for the plant based on the plant topology, the process model and the process data; providing the determined design parameter for further processing.

The term plant as used herein is to be understood broadly and relates to any system comprising two or more process equipments used to produce one or more products. The plant may be chemical plant used to process or produce a chemical compound (e.g. oil/gas/water suspension, or hydrogen carbonate). The plant may comprise a plurality of process equipments that are at least partially connected with each other in order to transfer an output of one process of equipment to another process equipment as input.

The term design parameter as used herein is to be understood broadly and relates to any parameter used to design, to adapt, and/or to optimize a plant. The design parameter may comprise a spatial arrangement of one or more process equipments to each other. The design parameter may relate to the plant topology. The design parameter may relate to the operation of a process equipment.

The term plant topology as used herein is to be understood broadly and relates to a selection of one or more process equipments and/or to a spatial or topological arrangement of one or more process equipments. The plant topology may comprise connection means for connecting process equipments. The plant topology may be a 3D model, a P&ID diagram, an input of a user, a set of MTPs (Module Type Package) and their interrelations, etc.

The term process equipment as used herein is to be understood broadly and relates to any device configured to produce, transfer, or to store an intermediate product product. The process equipment may comprise a vessel, storage means, a reactor, a heat exchanger or the like. The process equipment may comprise an inlet and an outlet. The process equipment may be connected with other process equipment by means of pipes and valves. The process equipment may receive as input an educt (e.g. H2O and ...) and energy (e.g. heat and/or electricity). The process equipment may provide as output a product (e.g. Hydrogen Carbonate) and waste energy (e.g. heat energy) and waste products (e.g. CO2). The process equipment may be represented in standard file formats such as MTP (Module Type Package) or using proprietary formats.

The term input parameter may relate to one or more input parameters. The term output parameter may relate to one or more output parameters.

The term process model as used herein is to be understood broadly and relates to any model configured to describe a relation between an input into a process equipment and an output of the process equipment. The process model may be an algebraic model, a simulation model, or a parameterized model. The process model may comprise an energy model comprising an energy consideration. The energy consideration may comprise type of energy, amount of the energy and/or time behavior (i.e. when and how does the respective energy usage/production occur). The process model may describe a chemical reaction. The process model may describe a behavior of one or more process steps conducted with the process equipment. The process model may be a time-dependent model.

The term process step as used herein is to be understood broadly and relates a step for producing a product. The process step may comprise heating, cooling, separating, distilling, mixing, reacting of two or more educts, storing, transferring.

The term process data as used herein is to be understood broadly and relates to data configured to describe one or more process steps of one or more process equipments. The process data may comprise an amount of a desired product and a corresponding amount of educts. The process data may comprise a range specification for process step for a specific parameter of the process model (e.g. temperature range). The process data may be used as input for the process model in order to determine the output.

The term further processing as used herein is to be understood broadly and relates to any way and manner to use the determined design parameter. The further processing may comprise creating of a new plant (or part of plant) comprising an adapted plant topology.

The term determining the design parameter is to be understood broadly and relates to a calculation or simulation of the design parameter. The determining of the design parameter may comprise an inputting of the process data in the respective process step of the respective process equipments and calculating the respective outputs and time behavior for the respective process steps. The determining of the design parameter may be an iterative process. The determining of the design parameter may comprise a search for undesired outputs (e.g. waste energy, CO2, H2O) of one or more process equipments that may be reused as input for other process equipments.

The invention is based on the finding that the plant topology can be optimized in order to reduce waste energy and increase energy reuse, or reduce waste water and increase water reuse, etc.. One approach is to use cogeneration systems, such as combined heat and power systems, which captured the heat generated during power generation and use it for heating or other processes. However, there is no automated procedure or system to consider the required energy in order to optimize these. This is usually done by a human expert in a tedious process, only after the actual process and automation engineering has taken place. The invention proposes a method for determining optimized design parameters for a plant, in particular for a plant topology. The determined design parameters lead to an optimized use of energy and to an optimization of energy flows. **The same proposed method can also be used not only for increase efficiency of energy, but also for water, CO2, etc.** The determined design parameters also enable an optimized use of byproducts (e.g. heat, CO2, H2O) generated during production. The method in general calculates based on the given plant topology and the received process data by using the process models the inputs and outputs for the respective process steps. The method compares the output of byproducts (e.g. energy, undesired products such as water or CO2) with demanded inputs and searches for a reuse of an output as an input.

In an embodiment, the input parameter may comprise at least one of the following: input energy, educt, amount of educt, process temperature, amount of water, amount of CO2; and the output parameter may comprise at least one of the following: output energy, product, amount product, amount of produced water, amount of produced CO2, amount of byproduct, duration of process step.

The term product means in the present case a desired product. The term byproduct means in the present case an undesired product (e.g. water or CO2) that is generated during the production of the desired product. The term output energy means in the present case waste, for example heat. It should be noted that the singular here may comprise a plurality.

In an embodiment, the design parameter may comprise at least one of the following: plant topology, additional process equipment, adapted process equipment size, adapted arrangement of process equipment in between plant topology, adapted process data.

In other words, the design parameter comprises an adapted setup for a plant. The adapted set for a plant may comprise an adapted plant topology and/or adapted process steps. The design parameter may comprise adapted process data. For example, instead of a process temperature range of 80 to 95°, the process temperature for the process step is set to 90° in order to reuse energy flows. The additional process equipment may for example comprise a storage means for storing waste energy or a heat exchanger. The adapted process equipment size may for example mean a bigger or smaller reaction container.

In an embodiment, the process data may comprise at least one of the following: temperature, temperature range, amount of educt and/or product. The process data may comprise one or more of the following: energy consumption, water consumption, water reuse, CO2 generation, CO2 reuse, CO2 transformation.

In an embodiment, the determining of the design parameters may comprise determining at least two different solutions for the design parameter, assessment of the at least two solutions, selecting one of the at least two solutions based on the assessment.

The assessment may be based on one or more assessment criteria. The assessment criteria may comprise acquisition costs, operating costs, energy consumption, water consumption, CO2 generation, educt consumption, unused byproduct generation.

In this way based on the assessment the best solution is selected. This may lead to a more efficient plant topology.

In an embodiment, the assessment may be based on a profitability assessment.

The profitability assessment may comprise a financial benefit calculation. The profitability assessment may consider acquisition costs and operating costs. For example, based on the profitability assessment a size of the process equipment (e.g. tank) may be selected.

In this way, the most economical solution may be selected. This may lead to a more efficient plant topology.

In an embodiment, the method may further comprise receiving input by means of an HMI for at least one of the following: plant topology, process model, process data, cost data.

In case not all information is available, experts may be able to input this information due to their expert knowledge or may provide input estimations. In this way, the flexibility and/or applicability of the method may be increased. Input means here at least part of the data for the plant topology, or at least a part of the data of the process model, or at least a part of the data of the process data or at least a part of the cost data.

In an embodiment, the determining of the design parameter may be based on an optimization algorithm.

The optimization algorithm may comprise a pinch analysis. This may be advantageous regarding energy consumptions. The optimization algorithm may comprise a cost optimization algorithm. The optimization algorithm may comprise a design optimization algorithm. The optimization algorithm may comprise a sensitivity analysis. In general, this may lead to a more efficient plant or plant topology.

In an embodiment, the determining of the design parameter may be based on a comparing of the output parameter of one of the plurality of process equipments with the input parameter of another one of the plurality of process equipments.

In this way, a possible reuse of an output of by byproducts or waste energy (e.g. water or heat) of process step for a necessary input of another process step can be found. In case a match is found, a possible adapted plant topology (e.g. connection pipe between the two respective process equipments and/or a heat exchanger) is determined.

In an embodiment, the determining of the design parameter may comprise inputting the process data into the respective process model for the respective process step.

In this way, the possible outputs and/or inputs for respective process steps for respective process equipment can be determined. The process data may serve as initial requirement for the calculation. For example, 50kg of chemical compound A have to be produced. This may require a specific amount of educts as input for respective process steps of respective process equipments.

In an embodiment, the determining of the design parameter may comprise considering a time behavior of the respective process step.

The process model may be a time dependent process model. The time behavior of a process step may relate to a duration of a process step. The determining of the design parameter may analyze the time behavior for example by checking when output of a process step is available and checking where and when the output (e.g. waste energy or undesired byproducts) may be reused. In case, an adequate input of process step is found, the design parameter may take into account an adapted plant topology (e.g. pipe between the process equipments, or a storage). Optionally based on the time behavior of the respective process steps also a rescheduling of the process steps may be determined such that an output may be reused. In general, this may lead to a more efficient plant.

In an embodiment, the further processing may comprise using the determined design parameter for at least one of the following: building the plant, operating the plant, retrofitting the plant.

The term building the plant means here designing/engineering a plant from the scratch. The term operating the plant means here that the plant already exists and only the process steps may be rescheduled or adapted (e.g. change of operation temperature). The term retrofitting means here that an existing plant is adapted by means of the method.

A further aspect of the present disclosure relates to a data processing device comprising means for carrying out the method described above.

A device according to one or more example embodiments may be implemented using hardware, software, and/or a combination thereof. For example, hardware devices may be implemented using processing circuitry such as, but not limited to, a processor, Central Processing Unit (CPU), a controller, an arithmetic logic unit (ALU), a digital signal processor, a microcomputer, a field programmable gate array (FPGA), a System-on-Chip (SoC), a programmable logic unit, a microprocessor, or any other device capable of responding to and executing instructions in a defined manner.

A device may include one or more interface circuits. In some examples, the interface circuits may include wired or wireless interfaces that are connected to a local area network (LAN), the Internet, a wide area network (WAN), or combinations thereof. The functionality of any given device or unit of the present disclosure may be distributed among multiple units or devices that are connected via interface circuits.

A device according to one or more example embodiments may also include one or more storage devices. The one or more storage devices may be tangible or non-transitory computer-readable storage media, such as random access memory (RAM), read only memory (ROM), a permanent mass storage device (such as a disk drive), solid state (e.g., NAND flash) device, and/or any other like data storage mechanism capable of storing and recording data. The one or more storage devices may be configured to store computer programs, program code, instructions, or some combination thereof.

Any disclosure and embodiments described herein relate to the methods, the systems, the devices, the computer program element lined out above and vice versa. Advantageously, the benefits provided by any of the embodiments and examples equally apply to all other embodiments and examples and vice versa.

As used herein "determining" also includes "initiating or causing to determine", "generating" also includes "initiating or causing to generate" and "providing" also includes "initiating or causing to determine, generate, select, send or receive". "initiating or causing to perform an action" includes any processing signal that triggers a computing device to perform the respective action.

A further aspect of the present disclosure relates to a computer program comprising instructions which, when the program is executed by a computer, cause the computer to carry out the method as described above.

A further aspect of the present disclosure relates to a computer-readable medium comprising instructions which, when executed by a computer, cause the computer to carry out the method as described above.

### BRIEF DESCRIPTION OF THE DRAWINGS

In the following, the present disclosure is described exemplarily with reference to the enclosed figures, in which
- Figure 1: shows an exemplary flow diagram of a method for determining a design parameter of a plant;
- Figure 2: shows a part of an exemplary initial plant topology; and
- Figure 3: shows an exemplary adapted plant topology.

### DETAILED DESCRIPTION OF EMBODIMENTS

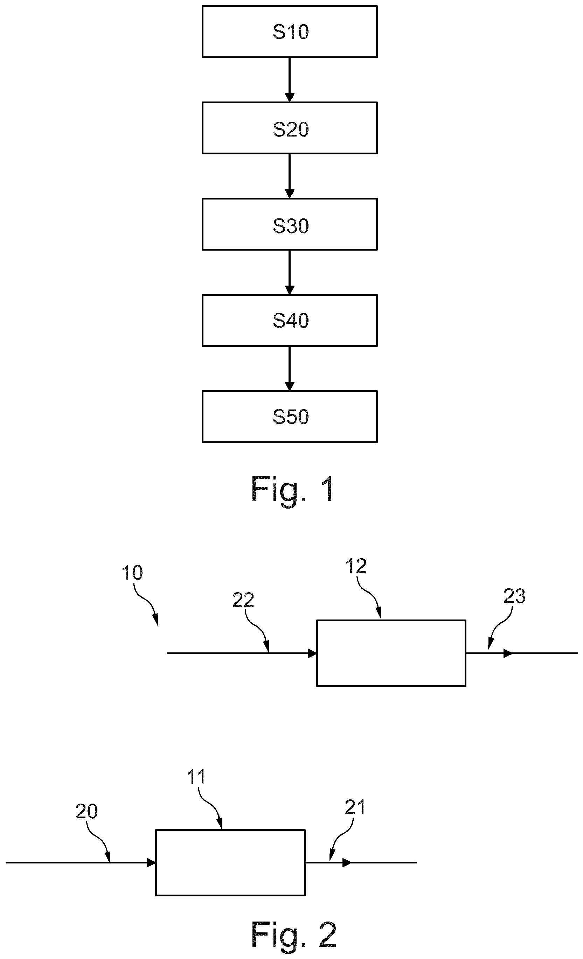

Figure 1 shows an exemplary flow diagram of a method for determining a design parameter of a plant.

Step S 10 comprises receiving a plant topology of the plant, wherein the plant topology comprises a plurality of process equipments. The plant may be a chemical plant for producing compound. The plant topology may be derived from a 3D model of the plant in the form of 3D model of the plant. The plant topology may be derived from a P&ID diagram or in the form of a P&ID diagram.

Step S 20 comprises receiving a process model for the respective process equipment for respective process step, wherein the process model describes a dependency between input parameter and an output parameter. For example, the plant topology comprises two process equipments (e.g. reactors). The method provides then for each of the two process equipments a respective process model. The process model may describe the chemical reaction, material flows and energy flows. The input parameter may comprise at least one of the following input energy, educt, amount of educt, process temperature, amount of water, amount of CO2. The output parameter may comprise at least one of the following output energy, product, amount of product, amount of produced water, amount of produced CO2.

Step S 30 comprises receiving process data for the respective process step for producing a product with the respective process equipment. The process data may comprise at least one of the following: temperature of the process, temperature range of the process, amount of educt, amount of product. The present example, the process data may comprise the temperature range and the desired amount of the product (e.g. chemical compound).

Step S 40 comprises determining the design parameter for the plant based on the plant topology the process model and the process data. The design parent meter may comprise at least one of the following: plant topology, additional process equipment, adapted process equipment size, adapted arrangement in between plant topology, and adapted processed data. In the present example, the design parameter may comprise an additional process equipment and an adapted plant topology (e.g., further a further connection pipe between the first process equipment and the second process equipment in order to transfer energy flows (e.g. heat and byproducts). The determining of the design parameter is carried out in the present example by inputting the process data into the respective process models for the respective process steps of the two process equipments. The method further determines the necessary inputs and corresponding outputs for the respective process steps. The method then compares the output of one process equipment with the input of the other process equipment and searches for a match. For example, the output energy of a process step of a first process equipment may be reused as input for a further process step of the second process equipment. Based on such a match, the method creates an adapted plant topology. For example, the plant topology comprises an additional connection pipe or heat exchanger between the two process equipments in order to transfer the energy. The determining may additionally comprise determining at least two different solutions for the design parameter. The two different solutions may be assessed by the corresponding costs, or their spatial demand or their equipment size. Based on the assessment of the two solutions, the best solution is selected. Additionally, the determining of the design parameter comprises considering a behavior of the respective process step. Based on the time behavior, either the process steps may be rescheduled, or storage means may be added to the plant topology in order to store outputs in case they are not needed at the time of generation. Additionally, the determining of the design parent meter may be based on optimization algorithm. The optimization algorithm may be for example a pinch analysis.

Step S 50 comprises providing the determined design parameter for further processing. The determined design parameter may be used may be used for billing the planned, operating the brand, and or and retrofitting the plant.

Figure 2 shows an exemplary initial plant topology 10. The plant topology comprises two process equipments 11 and 12. Each of the process equipments receives an input 20 and 22. Each of the process equipments provides an output 21 and 23. In the present example, the tool process equipments are operated independently from each other. In other words, the output of the respective process equipments is not reused as input for other process equipments. Such an exemplary plant topology serves as input for the method described above.

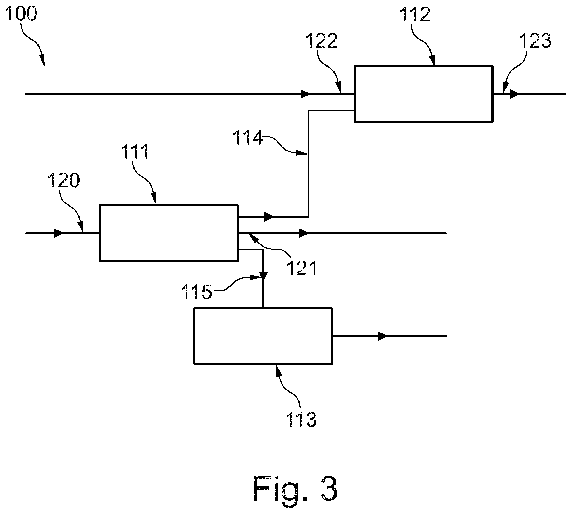

Figure 3 shows an exemplary adapted plant topology 100. The adapted plant topology 100 corresponds to the initial plant topology 10 in figure 2. The adapted plant topology is a result of the method described above. The determined design parameter leads to adapted plant topology 100. The adapted plant topology 100 comprises two process equipments 111 and 112 with inputs 120, 122 and outputs 121, 123 that correspond to figure 2. The adapted plant topology comprises further a connection pipe 114 that connects process equipment 111 and process equipment 112. The connection pipe 114 transfers byproducts (e.g. water and/or CO2) and waste energy (e.g. heat) from process equipment 111 to process equipment 112. The plant topology 100 comprises a further process equipment 113. The further process equipment is connected with process equipment by means of connection pipe 115. The further processing equipment is in the present example a storage means (e.g. heat energy or CO2) for a part of the output of the process equipment 111. The storage means may provide an energy flow and/or a material flow for reusing by another process equipment (not shown).

In the following, a summary of the main effects and main advantages of the present disclosure is provided:
In the engineering and planning phase of modular process plants, focus usually lies on the facilitation of the actual processes and of further processing the given inputs to the required outputs, according to given recipes and under consideration of chemical or physical restrictions, thereby using the available infrastructure, hardware, modules, and components.

Plant topologies can be optimized to reduce waste energy and increase energy reuse through a variety of methods. One approach may be to use cogeneration systems, such as combined heat and power (CHP) systems, which capture the heat generated during power generation and use it for heating or other processes. Additionally, heat integration systems (e.g., waste heat recovery systems) can be used to capture and reuse heat from industrial processes, such as in manufacturing plants or chemical refineries. These systems can help to significantly reduce energy costs and improve overall efficiency in a process plant. It may be necessary to consider the specific characteristics of the process and the needs of the facility when designing the topology of a plant.

However, to date, there is no automated procedure or system to consider the required & utilized energies or to optimize (i.e., minimize) these. Therefore, this is usually done by a human engineer/expert, e.g., by the plant owner, in a tedious process, only after the actual process and automation engineering has taken place.

This disclosure proposes a device and a method for automatically proposing optimization of resources (e.g energy usage and energy flows, material flows (e.g. water and CO2) in process plants.

The method or device may make use of the following (digitally available) input information:
Plant topology, e.g., via 3D-models or, more likely, P&ID diagrams, which expose, e.g., which modules or plant components are chained together in a specific process or in a set of processes or in an overall plant, and how their potential spatial arrangement and setup in the physical process plant is intended to look like.

Modules / PEAs / MTPs / components of the respective plant (possibly state-based) along with Energy Models that describe which variables and parameters affect the different physical quantities (such as temperatures, input/output energy, etc.) by means of functional parametrized dependencies (e.g., f(T) = m*T, with T a temperature, and m a tunable parameter; also multi-variate possible), so that energy flows can be made visible/tangible/usable. (e.g. it can be described, how usable the energy flow is or how "green" it is in sustainability/carbon-measurement contexts).

Knowledge of the different processes that occur in the process plants. For example, in a chemical plant, we know that a reaction process for product ABC can have an operating temperature range from T_min=700 to T_max=900 degrees Celcius, consuming for a product outcome of X tons a certain amount Y of energy over a certain time Z. Furthermore, the process model knows the process in detail. Using these pieces of information, the optimization algorithm can optimize different energy usage KPIs for the overall design/setup of the process plant.

Using the method or device, we can automatically exploit knowledge of the plant topologies, energy models, and process technology information to reach the following exemplary setups, check, ask and answer the following questions, and tackle use cases:
1. We know (using the process and energy models) which temperature/energy is needed per process step, as we know in which temperature range a process can run.
2. Using this we can predict the out coming amount and form (heat, steam) of "waste energy" according to the respective needs of a given process at the given time.
3. From the Plant topology and the respective models (process model), we can find process steps that could use the waste energy, considering form and time.
4. Based on further analysis the system can propose measures to optimize reuse of waste energy. Examples for measures can be:

Connecting two process assets via a heat exchanger that can serve as heat-source and heat sink with matching temperature levels.

Ensuring that a feed pipe of process step A passes through the waste heat area of process step B to enable pre-heating of material that goes into step A.

Moving two process steps closer to each other to reduce cooling in between them.

Using a "mechanical vapor recompression" system to upgrade waste heat to a higher level of temperature and/or pressure that can be reused in a different step.

Storing heat energy that would otherwise be wasted, to be used at a later point in time for a different or the same process step.

A chemical process, which for example in a first module requires 800 degrees, and in a last module only 100 degrees; Using our method or device, we would be able to figure out automatically, that the waste heat from the first module can be used as input heat for the last module.

A chemical process, in a more complex example: The device or method could help to find the most effective use of the heat in the overall plant, which may not be within the particular train of modules. Furthermore, the optimum use for the energy may change according to other conditions, e.g., reuse heat in the process immediately / create energy store / generate alternative energy vector (e.g. hydrogen).

Increasing the operating point of a module 1 (if the chemical domain knowledge admits this), because the waste energy could then be used in a module 2.

Other generic examples would be the support of sector-coupling, heat recovery, heat exchange.

Methodologies such as Pinch Analysis could be used for the underlying optimization algorithm. Pinch Analysis is a methodology used to minimize energy consumption of chemical processes by optimizing energy recovery methods. A pinch occurs at the closest point of approach between hot and cold streams in the network. By designing around this point, energy from utilities can be minimized. Minimizing the size and quantity of heat exchangers plays a large role in decreasing capital costs. There may be a trade-off between operational and capital costs (CAPEX vs OPEX). In some cases, transfer across the pinch is necessary to produce the optimal network.

Other use cases with respect to such trade-off considerations are possible, too, and may alternatively also use sensitivity analysis and design optimization.

Other general CAPEX/OPEX-Optimization potential may be given in direction of amortization of equipment/etc.

Analysis of batch process steps and their individual energy demands can identify optimization potential, e.g. making sure that different process steps using a lot of energy do not occur at the same time, to avoid consumption peaks. For example, ensuring that maximum (waste-) heat production happens at times when the energy can be ideally used downstream.

Understanding energy balances and their spatial and temporal order facilitates sizing of the components e.g.: heat exchanger and their pinch, depending on expected heat balances; heat storages based on simulation results; sector coupling elements (CHP, electrolyzer) based on additional use-cases of their secondary product (heat).

The method may work like this. Note that not all steps are mandatory and that the order may be amended.
1. At first, an inventory of all process equipment may be made, basing on the assets in the topology model.
2. The energy balance of each asset may be evaluated, based on an energy model, a simulation model, and the control code (FunctionBlock, SFC).
3. Energy surplus and demands of assets that are connected (topology model) may be compared and potential differences are highlighted; note, it will even work for unconnected assets, when the "one" process plant or the "one" plant context represents the connection.
4. Potentially positive (= waste energy) balances as well as balances of heat outlets (flare gas, cooling tower, cooling fans) may be collected and sorted by type and amount to "surplus energy cases".
5. For each "surplus energy case" (step 4) matching assets (concerning type and amount) may be searched in the inventory energy balances (step 2)
6. Depending on the simulation detail, the time behavior of the "surplus energy" may be considered and matched with possible energy sinks.
7. If reasonable and storage elements are available depending on the time behavior rescheduling of processes are proposed to better match energy surplus with respected sinks; overall production output should be maintained.
8. This could lead to suggestions of intermediate storage elements, e.g., tanks of intermediate process products.
9. Additional criteria can be evaluated on each of the cases in step3 and step5. Examples are: investment cost, spatial distance of the assets.
10. Additionally, if reasonable slightly modified operating points are suggested to better match sources with sinks while considering the overall costs; e.g., reducing heat exchanger cost and footprint (CAPEX cost) while increasing slightly production cost.
11. The individual possibilities from (6-8,10) are evaluated, e.g., in terms of cost and changes to the process and the most promising cases are presented to the user who can do any of the following:
   exclude the case from the list
   review the related parameters to identify deviations from specification.
12. With all remaining cases that have been validated and completed optimization calculations an optimization model can be set up and be run on existing optimization software in order to determine optimal asset sizing and financial benefit calculations.

Note, steps (6-8, 10) may alternatively also follow only after the selection of the case.

Note also, that (referring to step 11) there may be different optimization time scales, e.g.:
Short term - process operating points, batch scheduling, real time alternatives for energy use, e.g., reuse heat in process, use heat for other uses etc.
Medium term - suggestions for PEA orchestration, production planning.
Long term - suggestions for topology changes, e.g., intermediate storage, new connections, e.g., HX, new heat transfer lines.

Lastly, it is quite likely that not all relevant information is present in the implicitly available data (P&ID, MTP, topology, energy models) examples are:
Cost parameters or even cost-curves that give the dependency of CAPEX cost from a parameter;
Efficiency curves on how the efficiency of an assets changes with a parameter Variation;
Model details of new hardware to be added to the system;
Occurrence information on how often a certain SFC-step is executed or batch-type is processed.

For those missing parameters the inventive method can ask the user for specific input to finalize the optimization.

Moreover, when using modules and when working in the modular automation context, one can set up the energy model and domain knowledge once (i.e., only once), and ever and ever again re-use it, by putting it as input to the optimization engine, and taking the insights for planning the process plant setup.

A tool to automatically support the energetic optimization during setup/planning of a process plant would allow for recommending improvements to or even up to an optimal energetic/materialistic topology/layout of a process plant.

Furthermore, from this system and method, one could extract KPIs for "Sustainability" and "Circular Economy":
- Amount of energy required / re-used / saved / optimized
- Across plant boundaries (e.g., re-use CO2 from one process in another process, re-use waste material from one process as feedstock in another process)
- More generally: In the example above heat is most prominent, but the approach could also be used for other types of energy / elements etc.; such as CO2, H2O, 02, H2.

The device (or system) and method may allow for automatically proposing optimization of energy usage, energy flows, water usage and flows, CO2 usage and flows, etc. in process plants.

The method may comprise an algorithm for energy/water/CO2/etc optimization based on state-based energy/water/etc. models and topology information.

The method may enable to improve plant setup for higher resource efficiency, and hence better KPIs w.r.t. sustainability and energy/water/CO2 efficiency, as well as for CAPEX/OPEX-optimization.

The method may enable to automatically support the energetic optimization of a process plant during setup/planning.

Based on this system/device and method, we could recommend an optimal energetic topology/layout of a process plant in the early engineering phases.

Not only does it allow for achieving higher resource efficiency, and hence better KPIs w.r.t. sustainability and Energy Efficiency, but it is also generally useful for CAPEX/OPEX-optimization in the direction of amortization of equipment/etc.

Further benefits may arise when generalizing this idea beyond energy (and energy usage optimization) to other resources, such as water or CO2, etc.

### REFERENCE SIGNS

- S10: receiving a plant topology
- S20: receiving a process model
- S30: receiving process data
- S40: determining design parameter
- S50: providing design parameter

- 10: initial plant topology
- 11, 12: process equipment
- 20, 22: input process equipment
- 21, 23: output process equipment

- 100: adapted plant topology
- 111, 112: process equipment
- 113: further process equipment
- 114, 115: connection pipe
- 120, 122: input process equipment
- 121, 123: output process equipment

## Claims

1. A computer implemented method for determining a design parameter of a plant, comprising:
receiving a plant topology of the plant, wherein the plant topology comprises a plurality of process equipments (S10);
receiving a process model for the respective process equipment for a respective process step, wherein the process model describes a dependency between an input parameter and an output parameter (S20);
receiving process data for the respective process step for producing a product with the respective process equipment (S30);
determining the design parameter for the plant based on the plant topology, the process model and the process data (S40);
providing the determined design parameter for further processing (S50).

2. The method according to claim 1,
wherein the input parameter comprises at least one of the following: input energy, educt, amount of educt, process temperature, amount of water, amount of CO2;
wherein the output parameter comprises at least one of the following: output energy, product, amount product, amount of produced water, amount of produced CO2, duration of process step.

3. The method according to claim 1 or 2, wherein the design parameter comprises at least one of the following: plant topology, additional process equipment, adapted process equipment size, adapted arrangement in between plant topology, adapted process data.

4. The method according to any one of the preceding claims, wherein the process data comprises at least one of the following: temperature, temperature range, amount of educt and/or product.

5. The method according to any one of the preceding claims, wherein the determining of the design parameters comprises
determining at least two different solutions for the design parameter,
assessment of the at least two solutions,
selecting one of the at least two solutions based on the assessment.

6. The method according to claim 5, wherein the assessment is based on a profitability assessment.

7. The method according to any one of the preceding claims, further comprising receiving input by means of an HMI for at least one of the following: plant topology, process model, process data, cost data.

8. The method according to any one of the preceding claims, wherein the determining of the design parameter is based on an optimization algorithm.

9. The method according to any one of the preceding claims, wherein the determining of the design parameter is based on a comparing of the output parameter of one of the plurality of process equipments with the input parameter of another one of the plurality of process equipments.

10. The method according to any one of the preceding claims, wherein the determining of the design parameter comprises inputting the process parameter into the respective process model for the respective process step.

11. The method according to any one of the preceding claims, wherein the determining the design parameter comprises considering a time behavior of the respective process step.

12. The method according to anyone of the preceding claims, wherein the further processing comprises using the determined design parameter for at least one of the following: building the plant, operating the plant, retrofitting the plant.

13. A data processing device comprising means for carrying out the method according to any one of the claims 1 to 12.

14. A computer program comprising instructions, which, when the program is executed by a computer, cause the computer to carry out the method according to any one of the claims 1 to 12.

15. A computer-readable medium comprising instructions which, when executed by a computer, cause the computer to carry out the method according to any one of the claims 1 to 12.
